# EUROPÄISCHE PATENTSCHRIFT

(11) **EP 2 920 857 B1**
(45) Veröffentlichungstag und Bekanntmachung des Hinweises auf die Patenterteilung: **28.07.2021**
(21) Anmeldenummer: 13789278.2
(22) Anmeldetag: 07.11.2013
(51) Int. Cl.: H03K 17/687, H02H 9/04, H01F 27/40, G01R 1/36, G01R 15/18, H01F 38/32, H02H 7/04, H03K 17/082

(54) **SCHUTZSCHALTUNG FÜR EINEN STROMWANDLER UND STROMWANDLER MIT EINER SCHUTZSCHALTUNG**
PROTECTIVE CIRCUIT FOR A CURRENT TRANSFORMER AND CURRENT TRANSFORMER WITH A PROTECTION CIRCUIT
CIRCUIT DE PROTECTION POUR TRANSFORMATEUR DE COURANT ET TRANSFORMATEUR DE COURANT COMPRENANT UN CIRCUIT DE PROTECTION

(30) Priorität: 16.11.2012 DE 102012111061
(43) Veröffentlichungstag der Anmeldung: 23.09.2015
(73) Patentinhaber: Phoenix Contact GmbH & Co. KG, 32825 Blomberg (DE)
(72) Erfinder: JANKOWSKI, Martin, 30926 Seelze (DE)
(74) Vertreter: Blumbach · Zinngrebe Patentanwälte PartG mbB
(86) Internationale Anmeldenummer: PCT/EP2013/073305
(87) Internationale Veröffentlichungsnummer: WO 2014/075989

(56) Entgegenhaltungen:
- EP-A1- 1 304 786
- WO-A1-2004/040761
- DE-A1-102007 008 264
- US-A- 3 030 524
- US-A- 5 103 154
- US-A- 5 488 534
- US-A1- 2010 270 982
- US-A1- 2012 243 136

## Beschreibung

### Gebiet der Erfindung

Die Erfindung betrifft eine Schutzschaltung für einen Stromwandler zum Verhindern, dass eine Sekundärspannung an einem Sekundärkreis des Stromwandlers einen Sekundärspannungsschwellwert überschreitet. Die Erfindung betrifft ferner einen Stromwandler mit einer Schutzschaltung.

### Hintergrund der Erfindung

Stromwandler arbeiten im Allgemeinen in einem sekundärseitigen Kurzschluss, beispielsweise durch Einsatz eines Strommessgeräts im Sekundärkreis, da anderenfalls eine an den Sekundärklemmen stehende Spannung unzulässig hohe Werte annehmen kann. Um diesbezüglich einen Schutz des Wandlers bei Unterbrechung seines sekundärseitigen Kurzschlusses zu erzielen, beispielsweise bei Entfernung des Messgeräts einschließlich seines Shunt-Widerstands, sind Schutzschalter bekannt, die beim Auftreten unzulässig hoher Sekundärspannungen den Kurzschluss wieder herstellen.

Die bei einem offenen Sekundärkreis des Stromwandlers entstehenden Spannungsspitzen können sehr hoch und damit lebensgefährlich sein und können zudem zur Zerstörung des Stromwandlers führen.

Als Abhilfe sind Einrichtungen bekannt, die unverzögert, beispielsweise mittels Dioden oder Relais, oder verzögert kurzschließen. Für den verzögerten Kurzschluss sind Ausführungen bekannt, die periodisch, beispielsweise mittels eines Thermistors, oder dauernd, beispielsweise nach Erweichung eines Abstandhalters, kurzschließen.

Einrichtungen, die beim Abheben einer Sekundär-Abdeckung oder Abziehen eines Steckers kurzschließen, sind insofern problematisch, als sie bei Unterbrechung an anderer Stelle des Sekundärkreises nicht wirken.

Relais können so ausgeführt sein, dass sie den Stromwandler-Sekundärkreis nach Beseitigung der Unterbrechung selbsttätig und ohne größere Verzögerung wieder freigeben.

Eine solche Einrichtung lässt sich allerdings in einem Sekundärklemmenkasten eines Stromwandlers im Allgemeinen nicht unterbringen. Außerdem ist sie teuer und genügt hinsichtlich der Betriebssicherheit und Wetterbeständigkeit nicht immer den hohen betrieblichen Anforderungen.

So ist aus der FR 1 178 783 ein Schutzschalter bekannt, bei welchem ein spannungsabhängiges Schaltungselement beim Auftreten unzulässig hoher Sekundärspannungen einen von dem Stromwandler gespeisten Schalter betätigt. Parallel zur Sekundärwicklung und zur Bürde des Wandlers liegt eine Reihenschaltung von zwei antiparallel geschalteten Gleichrichtern und einem als Thermorelais ausgebildeten Relais. Falls die Sekundärspannung einen kritischen Wert erreicht, spricht das Relais an und schließt dabei einen Kontakt, der einen Kurzschlusspfad herstellt, der entweder nur die Gleichrichter oder die Reihenschaltung aus Gleichrichtern und Relais überbrückt.

Nachteilig bei diesem bekannten Schutzschalter ist, dass er eine hohe Trägheit besitzt, so dass sowohl das Ansprechen, als auch die Wiederherstellung des normalen Betriebszustandes nach Abklingen der unzulässig hohen Sekundärspannung, zeitverzögert ausgeführt werden. Ferner lässt sich ein solcher Schutzschalter, aufgrund seiner Größe, nur schwer im Sekundärklemmenkasten des Stromwandlers unterbringen, ist zudem teuer und ist problematisch hinsichtlich der Betriebssicherheit.

Die Europäische Offenlegungsschrift EP 1 304 786 A1 zeigt einen Spannungsbegrenzer zum Begrenzen von kurz- oder langzeitig anhaltenden Überspannungen mit einem Varistor und einem parallel zum Varistor schaltbaren Entlastungspfad.

Die U.S.-amerikanische Patentanmeldung US 2012/0243136 A1 zeigt ein Überspannungsschutzgerät für elektrische Schaltkreise mit einem Schalter, wobei die Überschussenergie in einem reaktiven Bauteil gespeichert wird.

Die deutsche Offenlegungsschrift DE 10 2007 008 264 A1 zeigt eine Schaltungsanordnung mit einem bidirektional sperrenden Halbleiterrelais, welches ein selbstsperrender MOSFET ist. Es wird dort eingesetzt zur Vermeidung des Einsatzes eines weiteren Halbleiter-Bauelements in Gegenrichtung.

### Allgemeine Beschreibung der Erfindung

Der Erfindung liegt die Aufgabe zugrunde, eine Schutzschaltung für einen Stromwandler hinsichtlich höherer Reaktionsgeschwindigkeit, höheren Belastungsstroms, höherer Betriebssicherheit, geringeren Bauvolumens und geringerer Herstellkosten weiterzuentwickeln.

Diese Aufgabe wird durch den Gegenstand der unabhängigen Ansprüche gelöst. Vorteilhafte Ausgestaltungen und Weiterbildungen sind in den abhängigen Ansprüchen angegeben. Die Merkmale der Weiterbildungen können, soweit technisch sinnvoll, miteinander und mit den Merkmalen der unabhängigen Ansprüche kombiniert werden.

Ein Aspekt der Erfindung betrifft eine Schutzschaltung für einen Stromwandler. Der Stromwandler ist im Wesentlichen ein kurzgeschlossener Transformator, der zum potentialfreien Messen von Wechselströmen verwendet wird. Er dient vorzugsweise zur Speisung von Strommessgeräten oder Energiezählern.

Die Primärwicklung des Stromwandlers besteht häufig aus einer einzigen Windung, beispielsweise einer Kupferschiene, während die Sekundärwicklung eine höhere Windungszahl hat. Das bedeutet, dass bei Leerlauf die Spannung des Primärkreises auf eine noch höhere Spannung im Sekundärkreis transformiert wird. Die hohe Spannung im Sekundärkreis kann zu einer Personengefährdung oder zu einer Zerstörung des Stromwandlers führen.

Die Schutzschaltung dient zum Verhindern, dass eine Sekundärspannung an einem Sekundärkreis des Stromwandlers einen Sekundärspannungsschwellwert überschreitet. Der Sekundärspannungsschwellwert kann beispielsweise einen bei der Herstellung der Schutzschaltung voreingestellter Wert oder einen durch eine Bedienperson einstellbaren Wert aufweisen.

Die Schutzschaltung weist gemäß der Erfindung einen Schutzschaltungseingang auf, vorzugsweise in Form von Kontaktstiften oder eines Klemmenpaares, der an den Sekundärkreis des Stromwandlers koppelbar ist, so dass die Sekundärspannung an dem Schutzschaltungseingang anliegt.

Die Schutzschaltung umfasst ferner eine mit dem Schutzschaltungseingang verbundene Steuereinheit auf, sowie eine mit dem Schutzschaltungseingang verbundene Schaltereinheit, die mit der Steuereinheit ansteuerbar verbunden ist.

Die Steuereinheit ist dazu ausgebildet, unter Ansprechen auf ein Überschreiten des Sekundärspannungsschwellwerts durch die Sekundärspannung, ein Steuersignal an die Schaltereinheit bereitzustellen. Der Wert der Sekundärspannung, der mit dem Sekundärspannungsschwellwert verglichen wird, kann eine Amplitude, ein Mittelwert, Momentanwert oder Effektivwert der Sekundärspannung sein.

Die Steuereinheit kann in Form einer elektronischen Schaltung, beispielsweise auf Halbleiterbasis, insbesondere in Gestalt eines integrierten Schaltkreises, implementiert sein.

Die Schaltereinheit ist dazu ausgebildet, unter Ansprechen auf das von der Steuereinheit bereitgestellte Steuersignal, den Schutzschaltungseingang kurzzuschließen. Das Steuersignal kann auf der Leitung, welche die Steuereinheit mit der Schaltereinheit verbindet, in Form einer Spannung bereitgestellt werden, die beim Überschreiten oder unter Ansprechen auf das Überschreiten des Sekundärspannungsschwellwerts ihren Wert ändert, beispielsweise von LOW auf HIGH oder umgekehrt.

Unter Kurzschließen des Schutzschaltungseingangs kann verstanden werden, dass das Schaltelement einen niederohmigen Widerstand in Höhe von weniger als 10 Ω, oder 1 Ω, oder 0,1 Ω, annimmt, der somit an den Schutzschaltungseingang geschaltet wird.

Die Schaltereinheit gemäß der Erfindung ist als eine Halbleiterschaltung ausgebildet. Die Halbleiterschaltung kann vorzugsweise als ein Halbleiterschalter oder Halbleiterrelais ausgebildet sein. Hierbei kann unter Halbleiterschalter ein auf Halbleiterbasis implementierter Schalter verstanden werden. Unter Halbleiterrelais kann ein auf Halbleiterbasis implementiertes Relais verstanden werden.

Die Schaltereinheit weist zwei in einer Back-to-Back Schaltung anti-seriell angeordnete MOSFETs auf, welche an einem Mittelanschluss miteinander verbunden sind. Hierbei können die Drain-Anschlüsse der Transistoren jeweils mit den Klemmen des Schutzschaltungseingangs verbunden sein, und die Gates können mit der Steuereinheit zum Zuführen des Steuersignals verbunden sein. Die Back-to-Back Schaltung ist vorteilhafter Weise für sehr hohe Ströme verwendbar. Zudem ist die Back-to-Back Schaltung wechselspannungsfähig, da ein Stromfluss in beide Richtungen möglich ist.

Die Steuereinheit umfasst ferner einen mit dem Schutzschaltungseingang verbundenen Gleichrichter zum Bereitstellen einer von einer Amplitude der Sekundärspannung abhängigen, insbesondere pulsierenden, Gleichspannung als Eingangsspannung der Komparatoreinheit.

Vorteilhafter Weise ermöglich der Gleichrichter eine Reaktion der Steuereinheit sowohl während negativer als auch positiver Halbwellen der Sekundärspannung, was eine weitere Verkürzung der Reaktionszeit ermöglicht. Hierfür weist der Gleichrichter vier Brückenzweige auf, wobei zwei Brückenzweige die Gleichspannung bereitstellen.

Zwei Brückenzeige des Gleichrichters sind mit dem Mittelanschluss der Schaltereinheit verbunden.

Gegenüber elektromechanischen Relais (EMR) bieten auf Halbleiterbasis implementierte Schalter oder Relais eine Vielzahl von Vorteilen:
- Halbleiterschalter sind typischerweise kleiner als EMRs, wodurch sich eine deutliche Platzeinsparung auf gedruckten Leiterplatten ergibt.
- Halbleiterschalter bieten eine bessere Systemzuverlässigkeit, da sie keine beweglichen Bauteile haben oder Kontakte die sich abnutzen könnten.
- Halbleiterschalter schalten prellfrei.
- Halbleiterschalter bieten bessere System-Lebenszeitkosten, einschließlich einer einfacheren Schaltung mit geringeren Anforderungen an Stromversorgung und die Wärmeabfuhr.
- Halbleiterschalter können Surface-Mount-Technologie (SMT) nutzen, was geringere Bestückungskosten und eine einfache Leiterplattenmontage zur Folge hat.
- Halbleiterschalter können nicht durch Magnetfelder beeinträchtigt werden.
- Halbleiterschalter sind unempfindlich gegenüber mechanischen Einflüssen wie Schock und Vibration.
- Halbleiterschalter erzeugen keine elektromagnetischen Störungen und sind auch nicht empfindlich gegenüber diesen Einflüssen (EMV, EMI).
- Halbleiterschalter können auf gedruckten Leiterplatten vorteilhaft wie ICs verarbeitet werden.

Ein weiterer Aspekt der Erfindung betrifft einen Stromwandler, vorzugsweise einen Durchsteckwandler, in dem eine Schutzschaltung gemäß obiger Beschreibung integriert ist.

Die Vorteile der Erfindung liegen darin, dass
- die Baugröße der Schutzschaltung gegenüber herkömmlichen Schutzschaltungen sehr viel geringer ist,
- ein Stromwandler mit integrierter Schutzschaltung bereitgestellt werden kann, der sich bezüglich seiner Abmessungen nicht oder nur geringfügig von einem herkömmlichen Stromwandler unterscheidet, und
- eine sehr geringe Reaktionszeit der Schutzschaltung gewährleistet ist.

Weitere Vorteile der Erfindung hängen unter anderen mit der Realisierung von Steuereinheit und Schaltereinheit auf Halbleiterbasis zusammen.

Die Merkmale der nachfolgenden Weiterbildungen und Ausführungsformen der Erfindung können mit den obigen Aspekten der Erfindung kombiniert werden.

Gemäß einer Ausführungsform kann die Steuereinheit direkt mit dem Schutzschaltungseingang verbunden sein.

Ferner kann die Schaltereinheit direkt mit dem Schutzschaltungseingang verbunden sein.

Hierbei heißt "direkt verbunden", dass die Komponente "Steuereinheit" und/oder "Schaltereinheit" unmittelbar an den Schutzschaltungseingang gekoppelt oder damit verbunden ist, wobei sich keine elektrischen oder mechanischen Elemente zwischen der Komponente und dem Schutzschaltungseingang befinden.

Die Schutzschaltung kann eine mit dem Schutzschaltungseingang verbundene Begrenzungseinheit für einen Überspannungsschutz umfassen. Die Begrenzungseinheit kann einen spannungsabhängigen Widerstand umfassen. Der spannungsabhängige Widerstand hat einen konstanten Wert, solange die an der Begrenzungseinheit anliegende Spannung unter einem Schwellwert liegt. Wenn die Spannung den Schwellwert überschreitet, reduziert der Widerstand seinen Wert, so dass sich der Strom durch den Widerstand erhöht und die am Widerstand anliegende Spannung den Schwellwert nicht überschreitet.

Vorteilhafter Weise ergänzen und unterstützen sich Begrenzungseinheit, Schalteinheit und Steuereinheit gegenseitig bezüglich der Schutzfunktion für den Stromwandler. Einerseits, weil die Schalteinheit für größere Ströme als die Begrenzungseinheit ausgelegt ist. Gemeinsam können die Komponenten Schalteinheit und Begrenzungseinheit einen größeren Strom ertragen als jede Komponente für sich allein.

Auf der anderen Seite unterstützt die Begrenzungseinheit die Steuereinheit, weil mittels der Parallelschaltung von Begrenzungseinheit und Steuereinheit eine definierte Spannung an den Eingang der Steuereinheit bereitgestellt oder ermöglicht wird. Damit kann die Wahrscheinlichkeit einer Beschädigung der Steuereinheit durch eine überhöhte Spannung am Eingang der Steuereinheit reduziert werden.

Zudem ermöglicht die Verwendung der Begrenzungseinheit einen Einsatz von Komponenten für die Steuereinheit und Schalteinheit, die nicht für hohe Spannungen ausgelegt sind, so dass dafür preiswerte Komponenten eingesetzt werden können.

Gemäß einer Ausführungsform kann die Steuereinheit eine Komparatoreinheit umfassen, welche dazu ausgebildet ist, das Steuersignal an die Schaltereinheit bereitzustellen, falls eine Eingangsspannung der Komparatoreinheit einen Schwellwert überschreitet.

Gemäß einer Ausführungsform kann die Komparatoreinheit einen Komparator umfassen mit einem positiven Eingang, einem negativen Eingang an welchem eine Spannung in Höhe von etwa der Eingangsspannung der Komparatoreinheit anliegt, und einem Ausgang, welcher das Steuersignal bereitstellt.

Die Komparatoreinheit kann ferner einen Spannungsteiler umfassen, wobei der positive Eingang mit der Eingangsspannung der Komparatoreinheit über den Spannungsteiler verbunden ist. Dadurch kann dem positiven Eingang des Komparators eine gemäß dem Teilungsverhältnis des Spannungsteilers reduzierte Eingangsspannung zugeführt werden.

Die Komparatoreinheit kann auch eine Zener-Diode umfassen, die mit dem negativen Eingang verbunden ist, zum Begrenzen einer am negativen Eingang anliegenden Spannung. Damit ist gewährleistet, dass am negativen Eingang des Komparators maximal die Durchbruchsspannung der Zener-Diode anliegt.

Die Komparatoreinheit kann einen Kondensator umfassen, der mit dem positiven Eingang verbunden ist.

Gemäß einer Ausführungsform kann die Schaltereinheit mehrere MOSFETs umfassen.

Die Schaltereinheit kann einen Optokoppler zum Einkoppeln des Steuersignals umfassen. Damit kann die Schaltereinheit gegenüber der Steuereinheit galvanisch entkoppelt werden.

Gemäß einer Ausführungsform kann die Begrenzungseinheit eine Suppressordiode (englisch: Transient Absorption Zener / TAZ-Diode, oder Transient Voltage Suppressor / TVS-Diode) umfassen. Die Suppressordiode bewirkt einen Schutz des Schutzschaltungseingangs, sowie aller damit verbundenen Komponenten wie Sekundärkreis, Steuereinheit oder Schaltereinheit, vor kurzzeitigen Überspannungsimpulsen.

Alternativ oder ergänzend kann die Begrenzungseinheit einen Varistor und/oder einen Gasableiter zum Schutz des Schutzschaltungseingangs vor kurzzeitigen Überspannungsimpulsen umfassen.

Gemäß einer Ausführungsform kann die Schutzschaltung unmittelbar an dem Stromwandler, genauer in dem Gehäuse des Stromwandlers, vorzugsweise in einem Sekundärklemmenkasten des Stromwandlers, beherbergt sein. Hierbei kann ein Stromwandlergehäuse derart ausgebildet sein, dass es den Sekundärklemmenkasten, in welchem Sekundärkreisklemmen des Stromwandlers angeordnet sind, sowie ein Sekundärkreisgehäuse, worin die Sekundärspule des Stromwandlers angeordnet ist, umfasst.

Eine derartige Unterbringung der Schutzschaltung ermöglicht für eine aus Stromwandler und Schutzschaltung bestehende Anordnung, aufgrund der kompakten Bauweise, eine erhöhte Beständigkeit gegen Witterungseinflüsse.

Die Erfindung wird nachfolgend anhand von Ausführungsbeispielen und unter Bezugnahme auf die Zeichnungen näher erläutert. Dabei verweisen gleiche Bezugszeichen auf gleiche oder entsprechende Elemente. Die Merkmale verschiedener Ausführungsbeispiele können miteinander kombiniert werden.

### Kurzbeschreibung der Figuren

Es zeigen:
- Fig. 1: eine schematische Darstellung einer ersten Ausführungsform der Schutzschaltung im Zusammenspiel mit einem Stromwandler,
- Fig. 2: eine schematische Darstellung einer zweiten Ausführungsform der Schutzschaltung im Zusammenspiel mit einem Stromwandler,
- Fig. 3: eine schematische Detail-Darstellung der zweiten Ausführungsform der Schutzschaltung,
- Fig. 4: ein Strom-Spannungs-Diagramm einer Suppressordiode,
- Fig. 5a: eine perspektivische Darstellung eines Stromwandlers, und

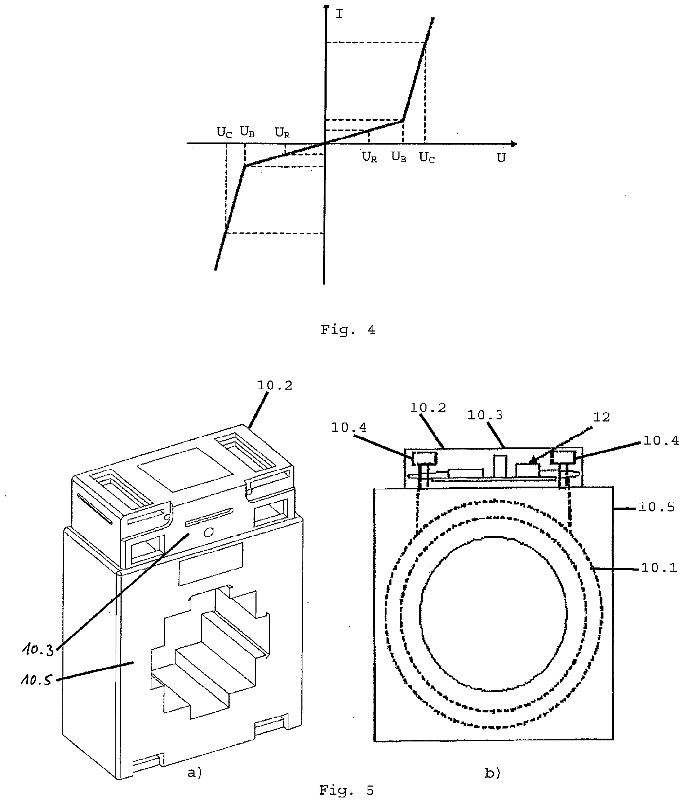

- Fig. 5a: eine Schnittdarstellung des Stromwandlers.

### Detaillierte Beschreibung der Erfindung

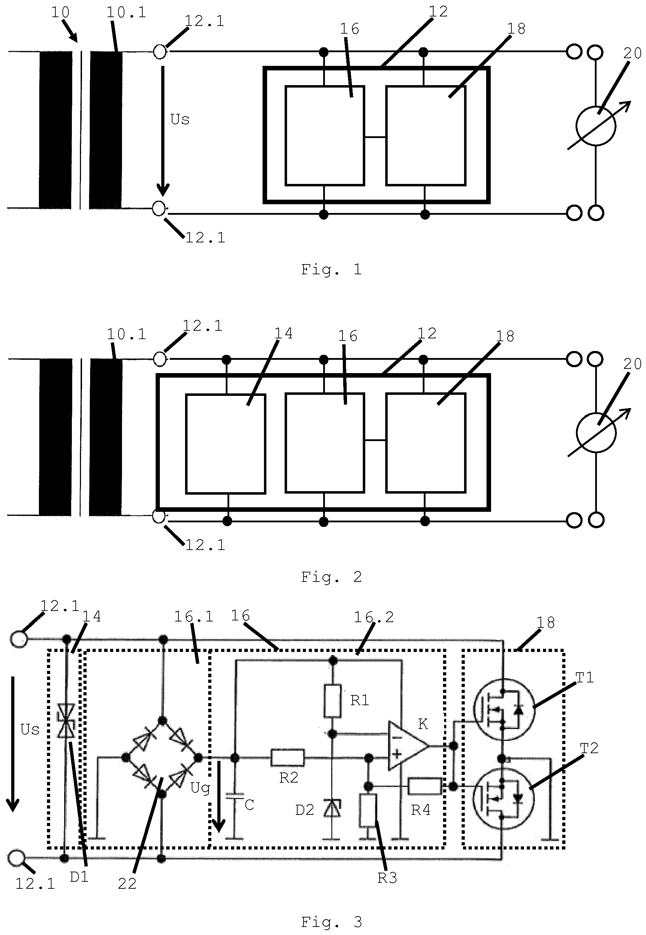

Die Fig. 1 zeigt ein erstes Ausführungsbeispiel der erfindungsgemäßen Schutzschaltung 12 für einen Stromwandler 10. Die Schutzschaltung 12 dient zum Verhindern, dass eine Sekundärspannung Us an einem Sekundärkreis 10.1 des Stromwandlers 10 einen Sekundärspannungsschwellwert überschreitet.

Die Schutzschaltung 12 umfasst
- einen Schutzschaltungseingang 12.1, der an den Sekundärkreis 10.1 des Stromwandlers 10 gekoppelt ist, so dass die Sekundärspannung Us an dem Schutzschaltungseingang 12.1 anliegt,
- eine mit dem Schutzschaltungseingang 12.1 verbundene Steuereinheit 16, und
- eine mit dem Schutzschaltungseingang 12.1 verbundene Schaltereinheit 18, die mit der Steuereinheit 16 ansteuerbar verbunden ist.

Die Steuereinheit 16 ist dazu ausgebildet, unter Ansprechen auf ein Überschreiten des Sekundärspannungsschwellwerts durch die Sekundärspannung Us, ein Steuersignal an die Schaltereinheit 18 bereitzustellen.

Die Schaltereinheit 18 ist dazu ausgebildet, unter Ansprechen auf das von der Steuereinheit 16 bereitgestellte Steuersignal, den Schutzschaltungseingang 12.1 kurzzuschließen.

In der Fig. 1 ist ferner ein Strommessgerät 20, das zum Messen des Stroms durch den Sekundärkreis 10.1 ausgebildet ist. Während des Messbetriebs ist das Auftreten einer Überspannung am Sekundärkreis 10.1 sehr unwahrscheinlich. Die Wahrscheinlichkeit für das Auftreten einer Überspannung oder überhöhten Sekundärspannung Us erhöht sich aber substantiell, sobald das Strommessgerät 20 vom Sekundärkreis 10.1 abgeklemmt wird, was in der Fig. 1 angedeutet ist.

Im Folgenden wird die Funktion der Schutzschaltung 12 erläutert.

Beim Auftreten einer überhöhten Sekundärspannung Us am Sekundärkreis 10.1 liegt an der Steuereinheit 16 eine Spannung an, welche einen voreingestellten Sekundärspannungsschwellwert überschreitet. Unter Ansprechen auf diese Überschreitung stellt die Steuereinheit 16 ein Steuersignal an die Schaltereinheit 18 bereit, welches beispielsweise von LOW auf HIGH wechselt. Unter Ansprechen auf das Steuersignal reduziert die Schalteinheit 18 ihren Innenwiderstand auf annähernd Null und schließt damit den Sekundärkreis 10.1 kurz.

Die Fig. 2 zeigt ein zweites Ausführungsbeispiel der erfindungsgemäßen Schutzschaltung 12 für einen Stromwandler 10. Im Unterschied zum ersten Ausführungsbeispiel umfasst die Schutzschaltung 12 gemäß dem in Fig. 2 gezeigten Ausführungsbeispiel eine Begrenzungseinheit 14, die parallel zur Steuereinheit 16 und zur Schaltereinheit 18 geschaltet ist und mit dem Sekundärkreis 10.1 verbunden ist.

Vorteilhafter Weise ergänzen und unterstützen sich Begrenzungseinheit 14, Schaltereinheit 18 und Steuereinheit 16 gegenseitig bezüglich der Schutzfunktion für den Stromwandler 12. Einerseits, weil die Schaltereinheit 18 für größere Ströme als die Begrenzungseinheit 14 ausgelegt ist. Gemeinsam können die Komponenten Schaltereinheit 18 und Begrenzungseinheit 14 einen größeren Strom ertragen als jede Komponente für sich allein.

Auf der anderen Seite unterstützt die Begrenzungseinheit 14 die Steuereinheit 16, weil mittels der Parallelschaltung von Begrenzungseinheit 14 und Steuereinheit 16 eine definierte Spannung an den Eingang der Steuereinheit 16 bereitgestellt wird.

Bekanntlich haben Suppressordioden, die bevorzugt für die Begrenzungseinheit 14 verwendet wird, nach Erreichen der Durchbruchspannung (siehe Fig. 4) noch einen endlichen Innenwiderstand, so dass sie nur Dauerströme führen können, die niedriger als die üblichen sekundären Nennströme von Wandlern sind. Dies ist ein möglicher Grund dafür, dass bisher keine Schutzschaltungen bekannt sind, die allein aus Suppressordioden bestehen.

Die zum Kurzschließen der Schaltereinheit 18 benötigte kurze Zeit stellt eine vernachlässigbar kleine Trägheit der Schutzschaltung 12 sicher, da die Steuereinheit 16 jede Halbwelle der Spannung am Sekundärkreis 10.1 "abtasten" kann. Sobald also die Spannung wieder unter einen vorgegebenen Grenzwert gesunken ist, wird in kürzester Zeit selbsttätig der durch die Schutzschaltung 12 hervorgerufene sekundärseitige Kurzschluss aufgehoben. Die Ansteuerung erfolgt periodisch.

Die Fig. 3 zeigt Details der in Fig. 2 dargestellten Ausführungsform der Schutzschaltung 12. Demnach umfasst die Steuereinheit 16 einen Gleichrichter 16.1 und eine Komparatoreinheit 16.2. Die Komparatoreinheit 16.2 umfasst:
- einen Komparator K mit einem positiven Eingang, einem negativen Eingang an welchem eine Spannung in Höhe von etwa der Eingangsspannung der Komparatoreinheit 16.2 anliegt, und einem Ausgang, welcher das Steuersignal bereitstellt;
- einen Spannungsteiler R2, R3, wobei der positive Eingang mit der Eingangsspannung der Komparatoreinheit 16.2 über den Spannungsteiler R2, R3 verbunden ist;
- eine Zener-Diode D2, die mit dem negativen Eingang verbunden ist, zum Begrenzen einer am negativen Eingang anliegenden Spannung;
- einen Kondensator C, der mit dem positiven Eingang verbunden ist.

Die Begrenzungseinheit 14 umfasst eine Suppressordiode D1. Eine Strom-Spannungs-Kennlinie der Suppressordiode D1 ist in Fig. 4 schematisch dargestellt. Hierin ist ersichtlich, dass die Suppressordiode D1 bidirektional im Rückwärtsbetrieb arbeitet. Die Durchlasskennlinie spielt hierbei keine Rolle. Markante Punkte der Kennlinie sind:
- UR äußerster Punkt der Sperrspannung (revers-stand-off voltage),
- UB Durchbruchspannung (break-down voltage),
- UC Begrenzungsspannung (clamping voltage).

Die Schaltereinheit 18 umfasst zwei in einer Back-to-Back Schaltung angeordnete MOSFETs T1, T2. Hierbei sind die Drain-Anschlüsse der Transistoren T1, T2 jeweils mit den Klemmen des Schutzschaltungseingangs verbunden, und die Gates sind mit dem Komparator K der Komparatoreinheit 16.2 zum Zuführen des Steuersignals verbunden.

Hierbei wird vorteilhafter Weise ein Kurzschluss automatisch mit den kleinen und leichten Halbleitern der zwei N-Kanal FETs hergestellt, die in der Back-to-Back Schaltung angeordnet sind.

Die beiden Transistoren T1, T2 schließen den Wechselstrom durch den Sekundärkreis 10.1 nahezu leistungsfrei kurz. Damit ist es möglich auch sehr hohe Ströme, wie beispielsweise einen thermischen Bemessungs-Kurzzeitstrom, welcher das 60-fache des Nennstroms von 5A, also 300 A, beträgt, für eine Sekunde abzuleiten und einen Bemessungs-Stoßstrom welcher das 2,5-fache des Bemessungs-Kurzzeitstroms, also 750 A, beträgt, für eine Halbwelle abzuleiten.

Der Kurzschluss wird ausgeführt, bevor die Spannung einen gefährlichen Wert überschreitet. Ein solcher Wert entspricht einem Quotienten von Bemessungsleistung und sekundärem Bemessungsstrom des Messwandlers.

Gemäß Fig. 3 wird die gleichgerichtete Spannung Ug durch den Komparator K, mit der Spannung an einer Zener-Diode D2 verglichen. Der Strom durch den Gleichrichter 22 lädt den Kondensator C auf, der die notwendige Spannung für den Komparator K und die Ansteuerung der Transistoren T1, T2 bereitstellt.

Sobald die Spannung am Eingang des Komparators K die Schwellspannung des Komparators K erreicht, wird der Sekundärkreis 10.1 kurzgeschlossen und der Kondensator C entlädt sich über R1, R2, R3, D1 und K, bis die Abschaltspannung am positiven Eingang des Komparators K wieder erreicht ist.

Wenn beispielsweise R4 sehr groß ist und zugleich R2, R3 gleich groß sind, dann ergibt sich ein Sekundärspannungsschwellwert in doppelter Höhe der Zener-Spannung. Die Parameter der Bauelemente der Steuereinheit 16, vorzugsweise die Parameter von R1, R2, R3, D1 und K, ermöglichen somit eine Festlegung des Sekundärspannungsschwellwerts, insbesondere im Verhältnis zur Sekundärspannung Us.

Die Betriebsspannung des Komparators K ist durch die Gleichrichterdioden vom Kurzschluss getrennt. Steht nach dem Entfernen des Kurzschlusses weiterhin eine zu hohe Spannung am Sekundärkreis 10.1 an, wird der Vorgang wiederholt, sodass die Einschaltspannung am positiven Eingang des Komparators K niemals überschritten werden kann.

Die Einschaltspannung und Ausschaltspannung am positiven Eingang des Komparators K sind über R4 durch eine Hysterese der Komparatoreinheit 16.2 getrennt, sodass keine undefinierten Schwingungen entstehen können. Die Schaltschwellen werden durch die Zener-Diode D2 und die eingestellte Hysterese bestimmt. Das Verhältnis der Widerstände R2, R3 zu dem Kondensator C bestimmt die Häufigkeit des Schaltvorganges.

Diese Schutzschaltung 12 kann in den Kopf des Stromwandlers 10 untergebracht werden und fest mit der Sekundärkreis 10.1 verbunden werden. Somit funktioniert der automatische Kurzschluss immer, unabhängig davon, wo der Sekundärkreis 10.1 unterbrochen wird.

Bei der Unterbringung der Schutzschaltung 12 beispielsweise in einem Schaltschrank, welcher die Komponenten einer Anlage beherbergt, an welche der Stromwandler 10 für eine Strommessung angeordnet ist, kann ein Verbindungskabel zur Schutzschaltung 12 an beliebiger Stelle zwischen Stromwandler 10 und Messgerät 20 unterbrochen werden, direkt oder unmittelbar an den Anschlüssen des Stromwandlers 10 oder des Messgerätes 20.

Die Schutzschaltung 12 kann auch nach Fertigstellung des Stromwandlers 10 in den Sekundärstromkreis eingefügt werden. Das heißt, ein Nachrüsten des Stromwandlers 10 mit der Schutzschaltung 12 ist möglich.

Eine Möglichkeit zur Verringerung der Kosten und Baugröße besteht darin, den Maximalstrom des Sekundärkreises 10.1 durch Variation des Materials des Stromwandlers 10 zu begrenzen. Durch angepasstes Kernmaterial kann der magnetische Fluss begrenzt werden, wodurch auch der Strom im Sekundärkreis 10.1 begrenzt wird.

Die Fig. 5a, 5b zeigen zwei Ansichten eines Stromwandlergehäuses 10.2, das einen Stromwandler 10 beherbergt. Das Stromwandlergehäuse 10.2 umfasst
- ein Sekundärkreisgehäuse 10.5, in welchem der Sekundärkreis 10.1 des Stromwandlers 10 untergebracht ist, und
- ein Sekundärklemmengehäuse 10.3, genannt auch "Sekundärklemmenkasten", in welchem Sekundärklemmen untergebracht sind, an denen die Sekundärspannung Us abgegriffen werden kann.

Die Schutzschaltung 12 ist in dem Stromwandlergehäuse 10.2, vorzugsweise im Sekundärklemmenkasten 10.3, untergebracht oder angeordnet. Die Schutzschaltung 12 ist direkt oder unmittelbar bei den Sekundärklemmen des Sekundärkreises 10.1 angeordnet. Die Schutzschaltung ist damit in dem Gehäuse 10.2 des Stromwandlers 10 vollständig integriert.

### Bezugszeichenliste

- 10: Stromwandler
- 10.1: Sekundärkreis des Stromwandlers
- 10.2: Stromwandlergehäuse
- 10.3: Sekundärklemmenkasten, Sekundärklemmengehäuse
- 10.4: Sekundärkreisklemmen
- 10.5: Sekundärkreisgehäuse
- 12: Schutzschaltung
- 12.1: Schutzschaltungseingang
- 14: Begrenzungseinheit
- 16: Steuereinheit
- 16.1: Gleichrichter
- 16.2: Komparatoreinheit
- 18: Schaltereinheit
- 20: Strommessgerät, Shunt-Widerstand
- D1: Suppressordiode
- D2: Zenerdiode
- K: Komparator
- R1-R4: Widerstände
- T1,T2: Transistoren
- Ug: Gleichspannung
- Us: Sekundärspannung

## Patentansprüche

1. Schutzschaltung für einen Stromwandler (10) zum Verhindern, dass eine Sekundärspannung (Us) an einem Sekundärkreis (10.1) des Stromwandlers (10) einen Sekundärspannungsschwellwert überschreitet, umfassend
- einen Schutzschaltungseingang (12.1), der an den Sekundärkreis (10.1) des Stromwandlers (10) koppelbar ist, so dass die Sekundärspannung (Us) an dem Schutzschaltungseingang (12.1) anliegt,
- eine mit dem Schutzschaltungseingang (12.1) verbundene Steuereinheit (16), und
- eine mit dem Schutzschaltungseingang (12.1) verbundene Schaltereinheit (18), die mit der Steuereinheit (16) ansteuerbar verbunden ist,
wobei
- die Steuereinheit (16) eine Komparatoreinheit (16.2) umfasst und dazu ausgebildet ist, unter Ansprechen auf ein Überschreiten des Sekundärspannungsschwellwerts durch die Sekundärspannung (Us), ein Steuersignal an die Schaltereinheit (18) bereitzustellen, falls eine Eingangsspannung der Komparatoreinheit (16.2) einen Schwellwert überschreitet,
- die Steuereinheit (16) ferner einen mit dem Schutzschaltungseingang (12.1) verbundenen Gleichrichter (16.1) zum Bereitstellen einer von einer Amplitude der Sekundärspannung (Us) abhängigen Gleichspannung (Ug) als Eingangsspannung der Komparatoreinheit (16.2) umfasst,
- die Schaltereinheit (18) als eine Halbleiterschaltung ausgebildet ist, die zwei in einer Back-to-Back Schaltung anti-seriell angeordnete MOSFETs (T1, T2) umfasst, welche an einem Mittelanschluss miteinander verbunden sind,
- der Gleichrichter (16.1) vier Brückenzweige umfasst, wobei zwei Brückenzweige die Gleichspannung (Ug) bereitstellen und zwei Brückenzweige mit dem Mittelanschluss der Schaltereinheit verbunden sind, und
- die Schaltereinheit (18) dazu ausgebildet ist, unter Ansprechen auf das von der Steuereinheit (16) bereitgestellte Steuersignal, den Schutzschaltungseingang (12.1) kurzzuschließen.

2. Schutzschaltung nach Anspruch 1, **gekennzeichnet durch** mindestens eines der folgenden Merkmale:
- die Steuereinheit (16) ist direkt oder unmittelbar mit dem Schutzschaltungseingang (12.1) verbunden;
- die Schaltereinheit (18) ist direkt oder unmittelbar mit dem Schutzschaltungseingang (12.1) verbunden;
- die Schutzschaltung (12) umfasst eine mit dem Schutzschaltungseingang (12.1) verbundene Begrenzungseinheit (14) für einen Überspannungsschutz.

3. Schutzschaltung nach einem der vorhergehenden Ansprüche, **dadurch gekennzeichnet, dass** die Komparatoreinheit (16.2) eine oder mehrere der folgenden Komponenten umfasst:
- einen Komparator (K) mit einem positiven Eingang, einem negativen Eingang an welchem eine Spannung in Höhe von etwa der Eingangsspannung der Komparatoreinheit (16.2) anliegt, und einem Ausgang, welcher das Steuersignal bereitstellt;
- einen Spannungsteiler (R2, R3), wobei der positive Eingang mit der Eingangsspannung der Komparatoreinheit (16.2) über den Spannungsteiler (R2, R3) verbunden ist;
- eine Zener-Diode (D2), die mit dem negativen Eingang verbunden ist, zum Begrenzen einer am negativen Eingang anliegenden Spannung;
- einen Kondensator (C), der mit dem positiven Eingang verbunden ist.

4. Schutzschaltung nach einem der vorhergehenden Ansprüche, **dadurch gekennzeichnet, dass** die Schaltereinheit (18) einen Optokoppler zum Einkoppeln des Steuersignals umfasst.

5. Schutzschaltung nach einem der vorhergehenden Ansprüche, **dadurch gekennzeichnet, dass** die Begrenzungseinheit (14) eine oder mehrere der folgenden Komponenten umfasst:
- eine Suppressordiode (D1);
- einen Varistor;
- einen Gasableiter.

6. Stromwandler mit einer Schutzschaltung (12) nach einem der vorhergehenden Ansprüche.

7. Stromwandler nach dem vorhergehenden Anspruch, **dadurch gekennzeichnet, dass** die Schutzschaltung (12) im Gehäuse (10.2), insbesondere im Sekundärklemmenkasten (10.3) des Stromwandlers (10) beherbergt ist.

## Claims

1. A protective circuit for a current transformer (10) for preventing a secondary voltage (Us) on a secondary circuit (10.1) of the current transformer (10) from exceeding a secondary voltage threshold, comprising:
- a protective circuit input (12.1) which can be coupled to the secondary circuit (10.1) of the current transformer (10) such that the secondary voltage (Us) is applied to the protective circuit input (12.1);
- a control unit (16) connected to the protective circuit input (12.1); and
- a switch unit (18) connected to the protective circuit input (12.1) and operatively connected to the control unit (16);
wherein
- the control unit (16) comprises a comparator unit (16.2) and is adapted to provide a control signal to the switch unit (18) in response to the secondary voltage (Us) exceeding the secondary voltage threshold, if an input voltage of the comparator unit (16.2) exceeds a threshold;
- the control unit (16) furthermore comprises a rectifier (16.1) connected to the protective circuit input (12.1), for providing a direct current voltage (Ug) which is a function of an amplitude of the secondary voltage (Us), as an input voltage for the comparator unit (16.2);
- the switch unit (18) is implemented as a semiconductor circuit which comprises two MOSFETs (T1, T2) arranged anti-serially in a back-to-back circuit, which are connected to one another at a central connection;
- the rectifier (16.1) comprises four bridge legs, with two bridge legs providing the direct current voltage (Ug) and two bridge legs being connected to the central connection of the switch unit; and
- the switch unit (18) is adapted to short-circuit the protective circuit input (12.1) in response to the control signal supplied from the control unit (16).

2. The protective circuit according to claim 1, **characterised by** at least one of the following features:
- the control unit (16) is directly or immediately connected to the protective circuit input (12.1);
- the switch unit (18) is directly or immediately connected to the protective circuit input (12.1);
- the protective circuit (12) comprises a limiting unit (14) for overvoltage protection, connected to the protective circuit input (12.1).

3. The protective circuit according to any one of the preceding claims, **characterised in that** the comparator unit (16.2) comprises one or more of the following components:
- a comparator (K) having a positive input, a negative input on which a voltage of approximately the level of the input voltage of the comparator unit (16.2) is applied, and an output which provides the control signal;
- a voltage divider (R2, R3), wherein the positive input is connected to the input voltage of the comparator unit (16.2) via the voltage divider (R2, R3);
- a Zener diode (D2) which is connected to the negative input, for limiting a voltage applied to the negative input;
- a capacitor (C) which is connected to the positive input.

4. The protective circuit according to any one of the preceding claims, **characterised in that** the switch unit (18) comprises an opt-isolator for introducing the control signal.

5. The protective circuit according to any one of the preceding claims, **characterised in that** the limiting unit (14) comprises one or more of the following components:
- a transient voltage suppression diode (D1);
- a varistor;
- a gas discharge tube.

6. A current transformer comprising a protective circuit (12) according to any one of the preceding claims.

7. The current transformer according to the preceding claim, **characterised in that** the protective circuit (12) is accommodated in the housing (10.2) of the current transformer (10), in particular in the secondary terminal box (10.3) thereof.

## Revendications

1. Circuit de protection pour transformateur de courant (10), destiné à empêcher qu'une tension secondaire (Us) sur un circuit secondaire (10.1) du transformateur de courant (10) ne dépasse une valeur seuil de tension secondaire, comprenant
- une entrée de circuit de protection (12.1) qui peut être couplée au circuit secondaire (10.1) du transformateur de courant (10), de manière à ce que la tension secondaire (Us) soit appliquée à l'entrée de circuit de protection (12.1),
- une unité de commande (16) reliée à l'entrée de circuit de protection (12.1), et
- une unité d'interrupteur (18) qui est reliée à l'entrée de circuit de protection (12.1) et est reliée avec possibilité d'activation à l'unité de commande (16),
dans lequel
- l'unité de commande (16) comprend une unité de comparateur (16.2) et est conçue pour réagir au dépassement de la valeur seuil de tension secondaire par la tension secondaire (Us) et fournir un signal de commande à l'unité d'interrupteur (18), si une tension d'entrée de l'unité de comparateur (16.2) dépasse une valeur seuil,
- l'unité de commande (16) comprend en outre un redresseur (16.1) qui est relié à l'entrée de circuit de protection (12.1) et est destiné à fournir une tension continue (Ug) dépendant d'une amplitude de la tension secondaire (Us), en tant que tension d'entrée de l'unité de comparateur (16.2),
- l'unité d'interrupteur (18) est réalisée sous forme de circuit à semi-conducteur comprenant deux MOSFETs (T1, T2) qui sont disposés dans un montage tête-bêche, dans une configuration anti-série, et sont reliés l'un à l'autre par une borne centrale,
- le redresseur (16.1) comporte quatre branches de pont, où deux branches de pont fournissent la tension continue (Ug) et deux branches de pont sont reliées à la borne centrale de l'unité d'interrupteur, et
- l'unité d'interrupteur (18) est agencée pour réagir au signal de commande fourni par l'unité de commande (16) et mettre en court-circuit l'entrée de circuit de protection (12.1).

2. Circuit de protection selon la revendication 1, **caractérisé en ce qu'**il présente au moins l'une des caractéristiques suivantes :
- l'unité de commande (16) est reliée directement ou indirectement à l'entrée de circuit de protection (12.1) ;
- l'unité d'interrupteur (18) est reliée directement ou indirectement à l'entrée de circuit de protection (12.1) ;
- le circuit de protection (12) comprend une unité de limitation (14) pour une protection contre les surtensions, qui est reliée à l'entrée de circuit de protection (12.1).

3. Circuit de protection selon l'une des revendications précédentes, **caractérisé en ce que** l'unité de comparateur (16.2) comprend un ou plusieurs des composants suivants :
- un comparateur (K) avec une entrée positive, une entrée négative, à laquelle est appliquée une tension d'une valeur correspondant approximativement à la tension d'entrée de l'unité de comparateur (16.2), et une sortie qui fournit le signal de commande ;
- un diviseur de tension (R2, R3), l'entrée positive étant connectée à la tension d'entrée de l'unité de comparateur (16.2) par l'intermédiaire du diviseur de tension (R2, R3) ;
- une diode Zener (D2) qui est reliée à l'entrée négative, en vue de la limitation d'une tension appliquée à l'entrée négative ;
- un condensateur (C) qui est relié à l'entrée positive.

4. Circuit de protection selon l'une des revendications précédentes, **caractérisé en ce que** l'unité d'interrupteur (18) comprend un coupleur optoélectronique destiné à coupler le signal de commande.

5. Circuit de protection selon l'une des revendications précédentes, **caractérisé en ce que** l'unité de limitation (14) comprend un ou plusieurs des composants suivants :
- une diode de suppression (D1) ;
- un varistor ;
- un élément d'évacuation de gaz.

6. Transformateur de courant doté d'un circuit de protection (12) selon l'une des revendications précédentes.

7. Transformateur de courant selon la revendication précédente, **caractérisé en ce que** le circuit de protection (12) est logé dans le boîtier (10.2), en particulier dans la boîte de bornes secondaires (10.3) du transformateur de courant (10).
